# EUROPÄISCHE PATENTSCHRIFT

(11) **EP 0 610 990 B1**
(45) Veröffentlichungstag und Bekanntmachung des Hinweises auf die Patenterteilung: **03.06.1998**
(21) Anmeldenummer: 94200217.1
(22) Anmeldetag: 31.01.1994
(51) Int. Cl.: H03L 7/085

(54) **Digitale Phasenregelschleife**
Digital phase-locked loop
Boucle à verrouillage de phase numérique

(30) Priorität: 05.02.1993 DE 4303356
(43) Veröffentlichungstag der Anmeldung: 17.08.1994
(73) Patentinhaber: LUCENT TECHNOLOGIES INC., Murray Hill, New Jersey 07974-0636 (US)
(72) Erfinder: Rosenkranz, Werner, Dr.-Ing., c/o Philips Patentv., D-20097 Hamburg (DE)
(74) Vertreter: Johnston, Kenneth Graham

(56) Entgegenhaltungen:
- DE-A- 2 543 171
- FR-A- 2 600 848
- US-A- 4 107 623
- US-A- 5 168 245

## Beschreibung

Die Erfindung bezieht sich auf eine digitale Phasenregelschleife gemäß dem Oberbegriff des Anspruchs 1.

In der Nachrichtentechnik ergibt sich häufig das Problem, einen Oszillator in Frequenz und Phase auf ein Referenzsignal abzustimmen. Zur Lösung des Problems kommen Phasenregelschleifen, sogenannte ,,Phase-Locked Loop" zur Anwendung. Man unterscheidet analoge Phasenregelschleifen, die mit analogen Signalen arbeiten, und digitale Phasenregelschleifen, die mit zeitdiskreten und/oder wertdiskreten Signalen innerhalb des Regelkreises arbeiten. Eine analoge Phasenregelschleife mit einem digitalen Vorwärts-Rückwärts-Zähler ist z.B. aus der DE-OS 25 43 171 bekannt. Eine digitale Phasenregelschleife mit einem Vorwärts-Rückwärts-Zähler ist z.B. aus der US 5,168,245 bekannt.

Aus der amerikanischen Patentschrift US-4,107,623 ist darüber hinaus eine Phasenregelschleife zur Synchronisation eines Oszillators mit einem Referenz-Oszillator in Frequenz und Phase bekannt, die eine analoge Regelschleife zur Fein- und eine digitale Regelschleife zur Grobeinstellung der Frequenz des Oszillatorsignals enthält. Durch den Einsatz der digitalen Regelschleife sind auch große Phasendifferenzen zwischen den beiden zu synchronisierenden Oszillatoren verarbeitbar.

Der Erfindung liegt die Aufgabe zugrunde, eine digitale Phasenregelschleife mit hoher Auflösung und großem Aussteuerungsbereich zu entwickeln.

Die Aufgabe wird erfindungsgemäß gelöst durch die Merkmale des Anspruchs 1.

In digitalen Nachrichtenübertragungssystemen ist es notwendig, den Takt eines Empfangssystems mit dem Takt des übertragenen Signals zu synchronisieren. Normalerweise wird der Takt des übertragenen Signals aus dem Datensignal abgeleitet. Der abgeleitete Takt, der das Ausgangssignal eines Oszillators im Empfangssystem darstellt, muß in Frequenz und Phase mit dem Takt des übertragenen Signals, das als Referenzsignal anzusehen ist, übereinstimmen. Zur Synchronisation des Oszillatorsignals mit dem Referenzsignal wird eine digitale Phasenregelschleife verwendet. Die digitale Phasenregelschleife enthält einen digitalen Regler, der leicht mit Hilfe eines Signalprozessors realisierbar ist. Ein geeigneter Regler für den hier vorliegenden Anwendungsfall ist beispielsweise ein PI-Regler. Dieser Regler enthält ein Proportional-Glied und ein Integral-Glied. Weiterhin ist ein steuerbarer Oszillator vorgesehen. Dessen Frequenz wird mit Hilfe der digitalen Ausgangssignale des Reglers eingestellt. An den Ausgang des Oszillators ist ein erster Eingang eines Phasendetektors gekoppelt, dessen zweiter Eingang zum Empfang eines Referenzsignals vorgesehen ist. Das Ausgangssignal des Phasendetektors bestimmt die Phasendifferenz von Referenz-und Oszillatorsignal. Der Ausgang des Phasendetektors ist mit dem Eingang des digitalen Reglers gekoppelt.

Um im stationären Zustand der digitalen Phasenregelschleife einen möglichst glatten Verlauf der Phase bzw. der Frequenz des Oszillatorsignals zu erreichen, ist es vorteilhaft, die Phasenregelschleife bzw. den digitalen Regler so zu dimensionieren, daß die Bandbreite der digitalen Phasenregelschleife gering ist. Eine geringe Bandbreite der Phasenregelschleife hat allerdings zur Folge, daß sich bei sprunghafter Änderung der Phasendifferenz von Referenz- und Oszillatorsignal, was insbesondere in der Anlaufphase der Phasenregelschleife auftritt, große Ausschläge der Phasendifferenz ergeben. Aus diesem Grunde muß der Phasendetektor einen großen Aussteuerungsbereich besitzen.

Im ersten Schaltungszweig des Phasendetektors wird aus der Zeitdifferenz zwischen Referenzpunkten von Referenz- und Oszillatorsignal, den Eingangssignalen des Phasendetektors, ein erster Wert abgeleitet. Dieser Wert ist insbesondere nur zur Beschreibung der Zeitdifferenzen zwischen benachbarten Referenzpunkten von Referenz- und Oszillatorsignal geeignet. Wenn jedoch zwischen zwei Referenzpunkten eines Eingangssignals des Phasendetektors mehrere Referenzpunkte des anderen Eingangssignals liegen, was beispielsweise einem Über- oder Unterschreiten einer entsprechenden Phasendifferenz von ganzzahligen Vielfachen von 2π entspricht, kann mit Hilfe des ersten Wertes die Phasendifferenz zwischen den Eingangssignalen des Phasendetektors nicht korrekt dargestellt werden. Der vom ersten Schaltungszweig gelieferte erste Wert kann Phasendifferenzen nur in einem beschränkten Bereich, beispielsweise nur im Bereich von 0 bis 2π beschreiben, in den auch außerhalb dieses Bereiches liegende Werte transformiert werden. Im Phasendetektor ist deshalb weiterhin ein zweiter Schaltungszweig angeordnet. Die dort angeordnete Zählvorrichtung wird an einem vorgebbaren Bezugszeitpunkt insbesondere auf Null rückgesetzt. Danach bildet sie die Differenz der detektierten Anzahl an Referenzpunkten des Referenzsignals und der detektierten Anzahl an Referenzpunkten des Oszillatorsignals. Die kleinere von zwei aufeinanderfolgenden Differenzen ist jeweils gleich dem vom zweiten Schaltungszweig gelieferten zweiten Wert, mit dem in Verbindung mit dem ersten Wert auch Phasendifferenzen von Referenz- und Oszillatorsignal beschrieben werden können, die über den nur mit dem ersten Wert darstellbaren Bereich hinausgehen. Insbesondere entspricht der zweite Wert ganzzahligen Vielfachen der Phasendifferenz von 2π.

Aus der Kombination vom ersten und zweiten Wert wird die Phasendifferenz zwischen den Eingangssignalen des Phasendetektors, d.h. von Referenz- und Oszillatorsignal, bestimmt. Der Phasendetektor besitzt vorteilhaft eine durch den ersten Schaltungszweig bewirkte hohe Auflösung und einen durch den zweiten Schaltungszweig bewirkten großen Aussteuerungsbereich.

Im ersten Zweig des Phasendetektors wird aus dem impulsförmigen Referenz- und Oszillatorsignal ein impulsförmiges Signal gebildet, dessen Impulse eine Breite besitzen, die dem zeitlichen Abstand von zwei bestimmten aufeinanderfolgenden Flanken von Oszillator und Referenzsignal entspricht. Die bestimmten Flanken sind in dieser Ausgestaltung in besonders vorteilhafter Weise als die oben erwähnten Referenzpunkte von Referenz- und Oszillatorsignal gewählt, da die Flanken eines Signals leicht detektierbar sind. Eine bestimmte Impulsflanke kann entweder eine aufsteigende oder abfallende Flanke eines Impulses sein. Ein Maß für die Phasendifferenz von Referenz- und Oszillatorsignal ist das Tastverhältnis des aus diesen beiden Signalen gewonnenen impulsförmigen Signales. Zur Bildung des momentanen Tastverhältnisses teilt man die Impulsbreite durch die Summe aus Impulsbreite und einer benachbarten Impulspausenbreite. Bei Angabe der Phasendifferenz in der Einheit rad entspricht einem Tastverhältnis von 0 die Phasendifferenz 0 und einem Tastverhältnis von 1 die Phasendifferenz 2π, wenn die bestimmten Flanken von Referenz-und Oszillatorsignal in beiden Fällen die aufsteigenden Flanken sind. Mit Hilfe des Tastverhältnisses ist nur eine Phasendifferenz im Bereich zwischen 0 und 2n beschreibbar. Überschreitet die Phasendifferenz beispielsweise den Wert 2π, so springt das Tastverhältnis vom Wert 1 auf den Wert 0. Allgemein gilt, daß das Tastverhältnis von dem Wert 1 auf den Wert 0 springt, wenn die Phasendifferenz positive oder negative ganzzahlige Vielfache von 2π überschreitet. Sind die bestimmten Flanken von Referenz- und Oszillatorsignal bei einem Signal die aufsteigenden und bei dem anderen Signal die abfallenden Flanken, so entspricht einem Tastverhältnis von 0 die Phasendifferenz π und einem Tastverhältnis von 0,5 die Phasendifferenz 0 bzw. 2π. Dies kann zur Verschiebung des Arbeitspunktes der Phasenregelschleife benutzt werden. Das aus dem Referenz- und Oszillatorsignal gebildete impulsförmige Signal wird einem Tiefpaßfilter zugeführt. Dessen Grenzfrequenz ist so niedrig gewählt, daß Frequenzanteile ab der Taktfrequenz von Referenz- und Oszillatorsignal stark gedämpft werden. Der Frequenzbereich, in dem Änderungen der Phasendifferenz von Referenz- und Oszillatorsignal liegen, umfaßt Frequenzen, die um Größenordnungen kleiner als die Taktfrequenz von Referenz- und Oszillatorsignal sind. Die Grenzfrequenz des Tiefpaß-Filters ist aber noch so groß, daß sprunghafte Änderungen des Tastverhältnisses des Eingangssignals des Tiefpaß-Filters, die beim Über- oder Unterschreiten von positiven oder negativen ganzzahligen Vielfachen von 2π der Phasendifferenz - im folgenden 2π-Bereichsüberschreitungen genannt - entstehen, durch steile Flanken am Ausgang des Tiefpaßfilters dargestellt werden. Das Tiefpaßsignal wird anschließend jeweils zur Bildung des oben genannten ersten Wertes abgetastet, quantisiert und mit einer ersten Anzahl an niederwertigen Bits codiert.

Der Eingang des zweiten Schaltungszweiges ist an den Eingang oder Ausgang des ersten Zweiges oder auch an einem Punkt innerhalb des ersten Zweiges gekoppelt. Die Impulsbreiten bzw. -pausen des impulsförmigen Signals, das auf den Tiefpaß des ersten Schaltungszweiges gegeben wird, werden durch zwei bestimmte Flanken von Referenz- und Oszillatorsignal bestimmt. Beispielsweise leitet eine bestimmte Flanke des Referenzsignals einen Impuls ein, eine darauffolgende bestimmte Flanke des Oszillatorsignals beendet diesen Impuls. Liegt zwischen zwei bestimmten Flanken des Referenzsignales genau eine bestimmte Flanke des Oszillatorsignals, liegt keine 2π-Bereichsüberschreitung der Phasendifferenz vor. Liegt zwischen zwei aufeinanderfolgenden bestimmten Flanken eines Eingangssignals des Phasendetektors allerdings mehr als eine bestimmte Flanke des anderen Eingangssignals, so liegt eine solche 2π-Bereichsüberschreitung vor. In diesen Fällen wird der Zählerstand der Zählvorrichtung, die im zweiten Schaltungszweig angeordnet ist, um den Wert 1 erhöht oder erniedrigt. Die Zählvorrichtung codiert ihren Zählerstand mit einer zweiten Anzahl an höherwertigen Bits.

Im ersten Schaltungszweig des Phasendetektors wird die Phasendifferenz von Referenz- und Oszillatorsignal mit einer feingestuften treppenförmigen Kennlinie quantisiert. Die Kennlinie weist im Abstand von jeweils 2π der Phasendifferenz Sprungstellen auf, die der Kennlinie einen sägezahnförmigen Verlauf geben. Im zweiten Schaltungszweig wird die Phasendifferenz mit einer grobgestuften treppenförmigen Kennlinie quantisiert. Der Beginn einer Treppenstufe liegt jeweils bei den Sprungstellen der ersten Kennlinie. Die Kennlinie des Phasendetektors erhält man durch Überlagerung der Kennlinien des ersten und zweiten Schaltungszweiges des Phasendetektors. Durch die Feinquantisierung im ersten Schaltungszweig erhält man eine hohe Auflösung des Phasendetektors, durch die im zweiten Schaltungszweig durchgeführte Grobquantisierung der Phasendifferenz erhält man einen großen Aussteuerungsbereich des Phasendetektors. Die Überlagerung der Quantisierungskennlinien des ersten und zweiten Schaltungszweiges des Phasendetektors entspricht einer Zusammenfassung der niederwertigen vom ersten Schaltungszweig gelieferten Bits mit den höherwertigen vom zweiten Schaltungszweig gelieferten Bits in Bitworten. Durch die hohe Auflösung des Phasendetektors werden nichtlineare Effekte wie z.B. Regelgrenzzyklen reduziert. Der große Aussteuerungsbereich des Phasendetektors bewirkt einen großen Fang- und Haltebereich der digitalen Phasenregelschleife.

Eine Weiterbildung der Erfindung ist dadurch gekennzeichnet, daß im ersten Schaltungszweig zur Bildung des impulsförmigen Signals ein Kippglied vorgesehen ist.

Um im ersten Schaltungszweig aus dem Referenz- und Oszillatorsignal ein impulsförmgiges die Phasendifferenz von Referenz- und Oszillatorsignal beschreibendes Signal zu erzeugen, ist eine Umsetzvorrichtung erforderlich. Eine solche Umsetzvorrichtung kann vorteilhaft als Kippglied ausgeführt werden, dessen Ausgangszustand kippt, wenn an den Eingängen ansteigende oder abfallende Flanken von Referenz- oder Oszillatorsignal liegen. Es ergibt sich eine einfache und kostengünstige Realisierung der Umsetzvorrichtung.

Vorteilhaft wird die Erfindung weiterhin dadurch ausgebildet, daß im zweiten Schaltungszweig die Zählvorrichtung als Vorwärts-Rückwärtszähler, an dessen Eingängen das Referenz- und das Oszillatorsignal anliegen, ausgebildet ist.

Die Funktion des zweiten Schaltungszweiges ist es, zu zählen, wie häufig und in welcher Richtung die Phasendifferenz positive oder negative ganzzahlige Vielfache von 2π über- bzw. unterschritten hat. Eine solche Zählvorrichtung kann beispielsweise durch einen Vorwärts-Rückwärts-zähler realisiert werden. Das Referenz- und das Oszillatorsignal werden auf zwei Eingänge dieses Zählers gegeben.

Der Zählerstand wird beispielsweise dann erhöht, wenn eine bestimmte Flanke des Referenzsignales am Zählereingang anliegt. Der Zählerstand wird um den Wert 1 erniedrigt, wenn am anderen Eingang des Zählers eine bestimmte Flanke des Oszillatorsignals anliegt. Die bestimmten Flanken von Referenz-und Oszillatorsignal können, wie oben erwähnt, entweder aufsteigende oder abfallende Flanken von Referenz- und Oszillatorsignal sein. Somit schwankt der Zählerstand fortlaufend. Der kleinere von zwei aufeinanderfolgenden Zählerständen gibt die zu zählenden Beiträge zur Phasendifferenz in Vielfachen von 2π an.

Eine andere Möglichkeit, die Erfindung zu erweitern, besteht darin, daß der Eingang des zweiten Schaltungszweiges des Phasendetektors zum Empfang des tiefpaßgefilterten impulsförmigen Signals des ersten Schaltungszweiges vorgesehen ist, daß am Eingang des zweiten Schaltungszweiges ein Differentiator bzw. Hochpaß angeordnet ist, daß an den Ausgang des Differentiators bzw. Hochpasses ein Schwellwertentscheider gekoppelt ist und daß an den Ausgang des Schwellwertentscheiders ein Vorwärts-Rückwärtszähler gekoppelt ist.

Bei hohen Frequenzen von Oszillator- und Referenzsignal ist es sinnvoll, einem Zähler diese Signale nicht direkt zuzuführen. Bei dieser Schaltungsanordnung wird das am Ausgang des Tiefpasses des ersten Schaltungszweiges des Phasendetektors anliegende Signal, das eine Phasendifferenz zwischen 0 und 2π beschreibt, einem Differentiator bzw. Hochpaß zugeführt. Der Hochpaß muß eine Grenzfrequenz besitzen, die kleiner als die Grenzfrequenz des Tiefpasses des ersten Schaltungszweiges ist. Mit Hilfe des Differentiators bzw. Hochpasses werden die steilen Flanken des am Ausgang des Tiefpasses des ersten Zweiges anliegenden die Phasendifferenz beschreibenden Signales herausgefiltert. Die steilen Flanken sind an den Stellen anzutreffen, an denen eine 2π-Bereichsüberschreitung vorliegt. Am Eingang des Differentiators bzw. Hochpasses anliegende steile Flanken des Eingangssignals werden in nadelförmige Impulse am Ausgang umgesetzt. Die restlichen Signalanteile des Eingangssignals werden stark gedämpft. Das so erzeugte Signal wird einem Schwellwertentscheider zugeführt. Immer dann, wenn ein positiver Nadelimpuls vorliegt, d.h. wenn ein positiver Schwellwert überschritten wird, gibt der Schwellwertentscheider einen ersten Zählimpuls auf einen Vorwärts-Rückwärtszähler. Bei einem Vorliegen negativer Nadelimpulse am Eingang des Schwellwertentscheiders, d.h. beim Unterschreiten einer negativen Schwelle des Schwellwertentscheiders, wird ein zweiter Zählimpuls auf den Vorwärts-Rückwärtszähler gegeben. Beim Anliegen eines ersten Zählimpulses am Vorwärts-Rückwärtszähler wird der Zählerstand um den Wert 1 verringert, beim Anliegen eines zweiten Zählimpulses wird der Zählerstand um den Wert 1 erhöht. Vorteilhaft wird eine Phasenregelschleife mit einem solchen Phasendetektor dann angewendet, wenn das Referenz- und das Oszillatorsignal sehr hochfrequent sind. Es treten immer nur bei 2π-Bereichsüberschreitungen der Phasendifferenz Zählimpulse am Eingang des Zählers der Zählvorrichtung auf. Die Frequenz der am Eingang des Zählers anliegenden Zählimpulse liegt um Größenordnungen unter der Taktfrequenz von Referenz- und Oszillatorsignal. Der Zählerstand des Zählers wird mit einer zweiten Anzahl an höherwertigen Bits codiert.

Schließlich besteht eine weitere Ausbildung der Erfindung darin, daß der zweite Schaltungszweig des Phasendetektors an den Ausgang des ersten Schaltungszweiges gekoppelt ist, daß der zweite Schaltungszweig im Digitalteil der digitalen Phasenregelschleife angeordnet ist, daß im zweiten Schaltungszweig Mittel zur Bildung der Differenz zweier aufeinanderfolgender mit einer ersten Anzahl an Bits codierter Abtastwerte der Phasendifferenz vorgesehen sind, daß diese Differenz einem Schwellwertentscheider zugeführt wird und daß Mittel zur Akkumulation der Ausgangswerte des Schwellwertentscheiders vorgesehen sind.

Häufig sind im Digitalteil der digitalen Phasenregelschleife, in dem auch der digitale Regler realisiert wird, noch Rechenkapazitäten frei. In diesem Fall ist es sinnvoll, den zweiten Schaltungszweig des Phasendetektors im Digitalteil der Phasenregelschleife anzuordnen. Dem zweiten Schaltungszweig werden in diesem Fall die am Ausgang des ersten Schaltungszweiges anliegenden niederwertigen Bits zugeführt. Vorteilhaft ergibt sich eine bessere Ausnutzung der Rechenkapazität des Digitalteils der Phasenregelschleife. Der zweite Schaltungszweig wird mit Hilfe eines Rechnerprogramms realisiert. Es sind keine zusätzlichen Bauteile zur Realisierung des zweiten Schaltungszweiges notwendig.

Ist die Abtastfrequenz, mit der die Phasendifferenz abgetastet wird, und die der Taktfrequenz im Digitalteil der Phasenregelschleife entspricht, groß gegen die Frequenzanteile der Phasendifferenz von Referenz- und Oszillatorsignal, so liegen die Abtastwerte der Phasendifferenz im ersten Schaltungszweig so dicht beieinander, daß die Phasendifferenzen, die zwei nebeneinandderliegenden Abtastwerten der Phasendifferenz entsprechen, klein gegen den Wert 2π sind. Die Differenz zweier aufeinanderfolgender Abtastwerte der Phasendifferenz im ersten Schaltungszweig wird auf einen Schwellwertentscheider gegeben, der beim Über- bzw. Unterschreiten einer geeigneten Schwelle einen positiven oder einen negativen Zählwert ausgibt. In den anderen Fällen liegt am Ausgang des Schwellwertentscheiders der Wert 0 an. Sprunghafte Veränderungen des Signalverlaufes im ersten Zweig, wie sie bei 2π-Bereichsüberschreitungen der Phasendifferenz auftreten, können somit detektiert werden. Die Ausgangswerte des Schwellwertentscheiders werden mittels eines Akkumulators aufsummiert. Der Akkumulator übernimmt damit die Funktion eines Zählers. Der Ausgangswert des Akkumulators wird mit der zweiten Anzahl an höherwertigen Bits codiert.

Eine Verarbeitung der Phasendifferenz gemäß einer nichtlinearen Kennlinie im Digitalteil der Phasenregelschleife vorgesehen ist eine weitere Möglichkeit, die Erfindung zu erweitern.

Um eine möglichst genaue Synchronisation des Referenz- und des Oszillatorsignales zu erreichen, ist es vorteilhaft, die Phasenregelschleife sehr schmalbandig auszulegen. Wie schon erwähnt treten bei schmalbandigen Phasenregelschleifen allerdings in der Anlaufphase der Synchronisation große Werte der Phasendifferenz von Referenz- und Oszillatorsignal auf. Der stationäre Zustand der Phasenregelschleife, d.h. der Arbeitspunkt, wird nur langsam erreicht. Die Kreisverstärkung, die das Produkt aller Verstärkungsfaktoren der Phasenregelschleife darstellt, steht im Zusammenhang mit der Bandbreite der Phasenregelschleife. Eine Erhöhung der Kreisverstärkung bewirkt eine erhöhte Bandbreite der Phasenregelschleife. Wird in der Anlaufphase der Phasenregelschleife, also bei hohen Phasendifferenzen von Referenz- und Oszillatorsignal, die Kreisverstärkung in Abhängigkeit der Phasendifferenz adaptiv erhöht, so läßt sich die Anlaufphase der Phasenregelschleife erheblich verkürzen. Der stationäre Arbeitspunkt der Phasenregelschleife wird vorteilhafterweise schneller erreicht als bei einer Phasenregelschleife ohne Adaption der Kreisverstärkung. Diese Adaption der Kreisverstärkung der Phasenregelschleife läßt sich in einem zusätzlichen Schaltungsblock realisieren, der zwischen Phasendetektor und digitalem Regler angeordnet ist. Ein weiterer Vorteil ist, daß die digitalen Signale in der Regelschleife weniger stark ausgesteurert werden. Die Wortbreite des digitalen Reglers kann somit verkürzt werden. Dieser Schaltungsblock kann auch am Ausgang des digitalen Reglers angeordnet werden. Er verarbeitet ein Eingangssignal gemäß einer nichtlinearen Kennlinie, deren Steigung mit ansteigender Phasendifferenz wächst. Die Steigung dieser Kennlinie entspricht einem Verstärkungsfaktor. Die nichtlineare Kennlinie kann mit Hilfe eines Rechnerprogramms realisiert werden. Vorteilhafterweise wird noch ungenutzte Rechenkapazität im Digitalteil der Phasenregelschleife genutzt und es sind damit keine zusätzlichen Schaltungsvorrichtungen notwendig.

Eine weitere Ausbildungs der Erfindung ist dadurch gekennzeichnet, daß die im zweiten Schaltungszweig erzeugten höherwertigen Bits mit einem Gewichtsfaktor multipliziert werden.

Die günstigen Wirkungen der oben beschriebenen im Digitalteil realisierten nichtlinearen Kennlinie können auch auf diese Weise erzielt werden. Die Stufenhöhen der Kennlinie des zweiten Schaltungszweiges des Phasendetektors werden auf die Weise vergrößert. Damit erhöht sich die mittlere Steigung der Gesamtkennlinie des Phasendetektors, die sich aus der Überlagerung der Kennlinien des ersten und zweiten Schaltungszweiges ergibt. Phasendifferenzen, die größer oder gleich 2π sind, werden mit einem Verstärkungsfaktor von der Phasenregelschleife weiterverarbeitet. Der Gewichtsfaktor ist beispielsweise leicht durch eine Bitverschiebung realisierbar. Es wird für eine solche Operation nur sehr wenig Rechenkapazität benötigt.

Ausführungsbeispiele der Erfindung werden nachstehend anhand der Zeichnungen näher erläutert. Es zeigen:
Fig. 1 eine digitale Phasenregelschleife,
Fig. 2 einen Phasendetektor mit zwei Schaltungszweigen,
Fig. 3 ein Simulationsmodell des Phasendetektors,
Fig. 4 und 5 zwei mögliche Kennlinien des Phasendetektors,
Fig. 6, 9 und 11 drei Ausführungsbeispiele des Phasendetektors der Phasenregelschleife,
Fig. 7 und 8 Zeitverläufe von Referenz- und Oszillatorsignal, sowie das die Phasendifferenz beschreibende jeweilige pulsbreitenmoduliertes Signal,
Fig. 10 beispielhafte Zeitverläufe von Phasendifferenz, Tiefpaßausgangssignal, Hochpaßausgangssignal und Zählerstand des Zählers im zweiten Schaltungszweig.

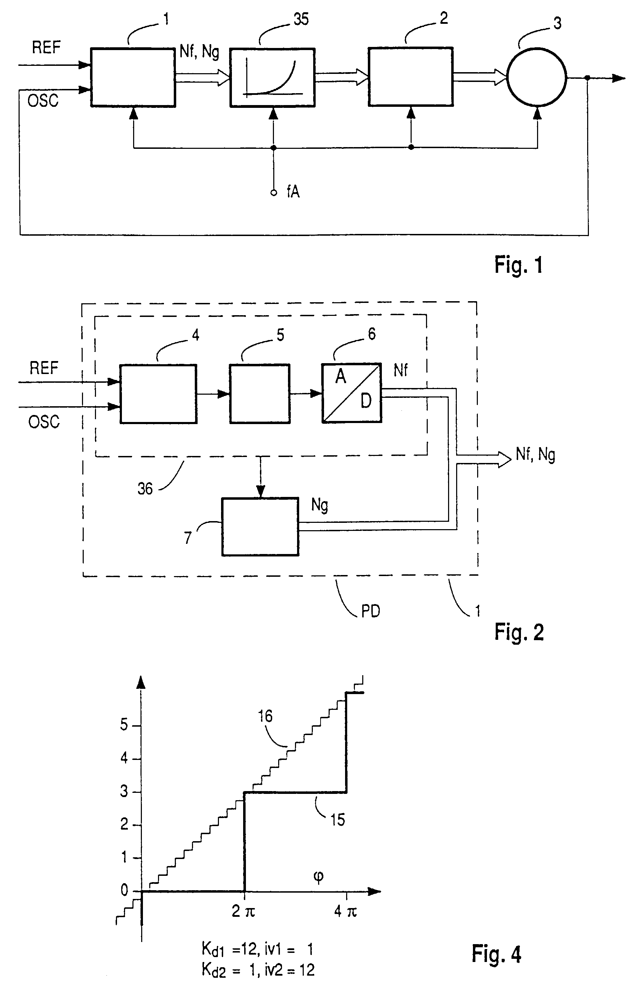

Die in Fig. 1 dargestellte digitale Phasenregelschleife enthält einen Phasendetektor 1, auf dessen zwei Eingänge ein Referenzsignal REF und ein Oszillatorsignal OSC gegeben werden. Der Phasendetektor 1 codiert Phasendifferenzen zwischen dem Referenzsignal und dem Oszillatorsignal mit einer ersten Anzahl Nf an niederwertigen Bits und einer zweiten Anzahl Ng an höherwertigen Bits. Der Ausgang des Phasendetektors 1 ist mit dem Eingang eines optionalen Schaltungsblockes 35 gekoppelt, der ein Eingangssignal gemäß einer nichtlinearen Kennlinie verarbeitet. Die Steigung dieser Kennlinie, die einem Verstärkungsfaktor entspricht, hat bei kleinen Eingangswerten den Wert 1 und nimmt mit zunehmendem Eingangswert zu. Somit erhöht sich bei großen Phasendifferenzen die Kreisverstärkung der Phasenregelschleife, die sich aus dem Produkt aller Verstärkungsfaktoren der Phasenregelschleife zusammensetzt. Die Bandbreite der Phasenregelschleife nimmt bei erhöhter Kreisverstärkung zu, der Einschwingvorgang wird beschleunigt und der Arbeitspunkt zu einem frühen Zeitpunkt erreicht. Der Aussteuerungsbereich und damit die notwendige Wortbreite im Digitalteil der Phasenregelschleife werden reduziert. An den Ausgang dieses Schaltungsblockes 35 ist ein digitaler Regler 2 gekoppelt. Der digitale Regler 2 ist beispielsweise ein PI-Regler. Der Ausgang des Reglers 2 ist mit dem Eingang eines steuerbaren Oszillators 3 gekoppelt. Der steuerbare Oszillator 3 wird durch die digitalen Ausgangssignale des digitalen Reglers 2 gesteuert. Der Ausgang des Oszillators 3, an dem das impulsförmige Oszillatorsignal anliegt, ist mit einem Eingang des Phasendetektors verbunden.

Sowohl Phasendetektor 1, Schaltungsblock 35 als auch der digitale Regler 2 und der steuerbare Oszillator 3 werden mit einem Taktsignal der Frequenz fA versorgt. Die Frequenz fA stellt die Abtastfrequenz der Phasendifferenz von Referenz- und Oszillatorsignal dar. Das impulsförmige Ausgangssignal des steuerbaren Oszillators 3 wird abgegriffen und beispielsweise zur Taktversorgung im Empfangsteil eines Nachrichtenübertragungssystems verwendet.

Fig. 2 zeigt den Aufbau des Phasendetektors 1 der digitalen Phasenregelschleife. Er ist aus zwei Schaltungszweigen aufgebaut. Auf die zwei Eingänge des ersten Schaltungszweiges 36 des Phasendetektors, die gleichzeitig die zwei Eingänge des Phasendetektors sind, werden ein impulsförmiges Referenzsignal REF und ein impulsförmiges Oszillatorsignal OSC gegeben und somit einer am Eingang des ersten Schaltungszweiges angeordneten Umsetzvorrichtung 4 zugeführt. Diese setzt den Zeitverlauf von Referenz- und Oszillatorsignal in ein impulsförmiges Signal um, dessen Impulslängen und Impulspausen bzw. dessen Tastverhältnis durch den zeitlichen Verlauf der Phasendifferenz bestimmt ist, was einer Pulsbreitenmodulation entspricht. Der Ausgang des Phasendetektors 4 ist mit dem Eingang eines Tiefpasses 5 gekoppelt. Der Tiefpaß 5 setzt das pulsbreitenmodulierte Ausgangssignal der Umsetzvorrichtung 4 in ein amplitudenmoduliertes analoges Signal um. Das Ausgangssignal des Tiefpasses 5 wird einem Analog-Digital-Umsetzer 6 zugeführt, der eine Abtastung, Quantisierung und Codierung mit Nf Bits durchführt.

Ein zweiter Schaltungszweig 7 ist an den Eingang, den Ausgang oder einen Punkt innerhalb des ersten Schaltungszweiges gekoppelt. In diesem Schaltungszweig 7 ist eine Zählvorrichtung angeordnet, die ihren Zählerstand um den Wert 1 erhöht bzw. erniedrigt, wenn die Phasendifferenz von Referenz- und Oszillatorsignal ein positives oder negatives ganzzahliges Vielfaches von 2π überschreitet bzw. unterschreitet (im folgenden 2π-Bereichsüberschreitung der Phasendifferenz genannt). Der Zählerstand wird mit Ng höherwertigen Bits codiert.

Die niederwertigen vom ersten Schaltungszweig gelieferten Nf Bits und die höherwertigen vom zweiten Schaltungszweig gelieferten Ng Bits werden zusammengefaßt. Sie liefern einen Zahlenwert zur Beschreibung der Phasendifferenz von Referenz- und Oszillatorsignal in einem beliebig erweiterbaren Meßbereich.

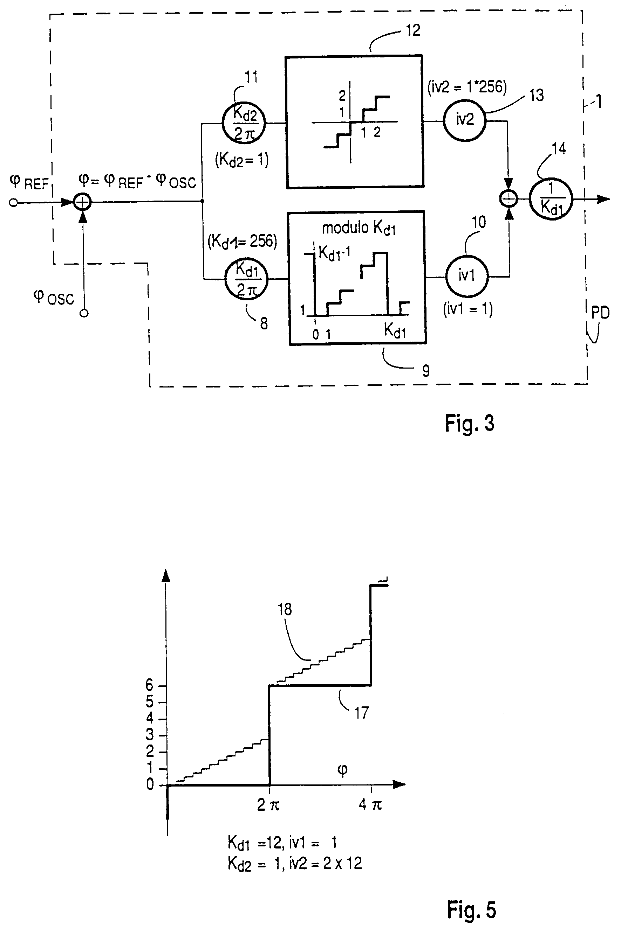

In Fig. 3 ist ein Simulationsmodell des Phasendetektors der digitalen Phasenregelschleife dargestellt. Ein Rechnerprogramm, das nach diesem Simulationsmodell programmiert wurde, dient zur Ermittlung der Eigenschaften des Phasendetektors. Am Eingang des Modells wird die Phasendifferenz von Referenz- und Oszillatorsignal gebildet. Dieser digital vorliegende Zahlenwert für die in der Einheit rad angegebene Phasendifferenz wird einem ersten Funktionszweig zugeführt, der den ersten Schaltungszweig des Phasendetektors simuliert. Ein Funktionsblock 8 normiert die Phasendifferenz auf den Wert 2π und führt eine Multiplikation mit dem Faktor Kdl durch. Anschließend wird mit Hilfe eines Funktionsblockes 9 eine Quantisierung mit einer sägezahnförmigen Kennlinie durchgeführt. Die Quantisierung erfolgt modulo Kdl. Die Quantisierungskennlinie besitzt Kd1 Stufenhöhen der Höhe 1. Einem beliebig großen Definitionsbereich wird ein beschränkter Wertebereich mit Werten zwischen 0 und Kd1-1 zugewiesen. Die vom Funktionsblock 10 gelieferten Zahlenwerte werden mit einem Faktor iv1 multipliziert.

Der die Phasendifferenz ϕ darstellende Zahlenwert wird außerdem einem zweiten Funktionszweig, der den zweiten Schaltungszweig des Phasendetektors simuliert, zugeführt. Ein Funktionsblock 11 führt eine Normierung auf den Wert 2π und eine Multiplikation mit dem Wert Kd2 durch. Der so erhaltene Zahlenwert wird durch einen Funktionsblock 12 mit einer treppenförmigen Kennlinie mit der Stufenhöhe 1 quantisiert. Diese Kennlinie besitzt einen nur durch den verfügbaren Zahlenbereich beschränkten Definitions- und Wertebereich. Die so erhaltenen Zahlenwerte multipliziert ein Funktionsblock 13 mit einem Faktor iv2.

Die Ausgangswerte des ersten und zweiten Funktionszweiges werden addiert und von einem Funktionsblock 14 durch den Wert Kdl geteilt.

Im ersten Funktionszweig wird eine Feinquantisierung durchgeführt. Die Kd1 Stufenhöhen der Quantisierungskennlinie des Funktionsblockes 9 lassen sich mit Nf niederwertigen Bits quantisieren. Im vorliegenden Beispiel sind 256 Stufenhöhen bzw. eine Codierung mit Nf=8 Bits vorgesehen. Der erste Funktionszweig liefert Zahlenwerte von 0 bis 255, die Phasendifferenzen zwischen 0 und 2π entsprechen.

Der zweite Funktionszweig führt eine Grobquantisierung und eine Codierung mit Ng Bits von den die Phasendifferenz darstellenden Zahlenwerten durch. Der Aussteuerungsbereich der Grobquantisierungskennlinie hängt nur von der Anzahl Ng an höherwertigen Bits ab, die zur Codierung der Stufenhöhen zur Verfügung stehen. Der Faktor iv2 ist im vorliegenden Beispiel zu 256 gewählt. Damit hat die Stufenhöhe der Kennlinie des zweiten Funktionszweiges den Wert 256.

Die sich aus der Überlagerung von Fein- und Grobquantisierungskennlinie ergebende Gesamtquantisierungskennlinie des Phasendetektors vereint die Vorteile von hoher Auflösung der Feinquantisierungskennlinie und des großen Aussteuerungsbereichs der Grobquantisierungskennlinie. Die Höhe der Sprünge der sägezahnförmigen Kennlinie des ersten Funktionszweiges ist gleich der Stufenhöhe der treppenförmigen Kennlinie des zweiten Funktionszweiges. Die Gesamtquantisierungskennlinie hat somit einen "glatten" Verlauf.

Durch die Division der Summe der Ausgangswerte von erstem und zweitem Funktionszweig durch den Zahlenwert Kd1 wird eine Normierung erreicht. Beispielsweise entspricht jetzt eine Zahlenwertdifferenz 1 einer Phasendifferenz von 2π.

Die Fig. 4 und 5 verdeutlichen, wie sich die Quantisierungskennlinien des ersten und zweiten Schaltungszeiges zu einer einzigen Quantisierungskennlinie addieren. In Fig. 4 ist die Quantisierungskennlinie des zweiten Schaltungszweiges dargestellt. Die Funktionswerte der Kennlinie 15 und die Funktionswerte einer nicht dargestellten sägezahnförmigen Quantisierungskennlinie des ersten Schaltungszweiges werden addiert. Es ergibt sich die Quantisierungskennlinie 16, die den großen Aussteuerungsbereich der Quantisierungskennlinie des zweiten Schaltungszweiges mit der hohen Auflösung der Quantisierungskennlinie des ersten Schaltungszweiges verbindet. In Fig. 5 ist die Stufenhöhe der Quantisierungskennlinie des zweiten Schaltungszweiges verdoppelt. Die Quantisierungskennlinie des ersten Schaltungszweiges ist unverändert. Für Phasendifferenzen größer als 2π ergibt sich ein zusätzlicher Verstärkungsfaktor, der die Kreisverstärkung erhöht. Phasendifferenzen größer als 2π treten vor allem in der Anlaufphase der Phasenregelschleife auf. Durch Erhöhen der Kreisverstärkung, die das Produkt aller Verstärkungsfaktoren der Phasenregelschleife darstellt, wird die Bandbreite der Phasenregelschleife erhöht und der Einschwingvorgang verkürzt. Der stationäre Zustand der Phasenregelschleife wird schneller erreicht.

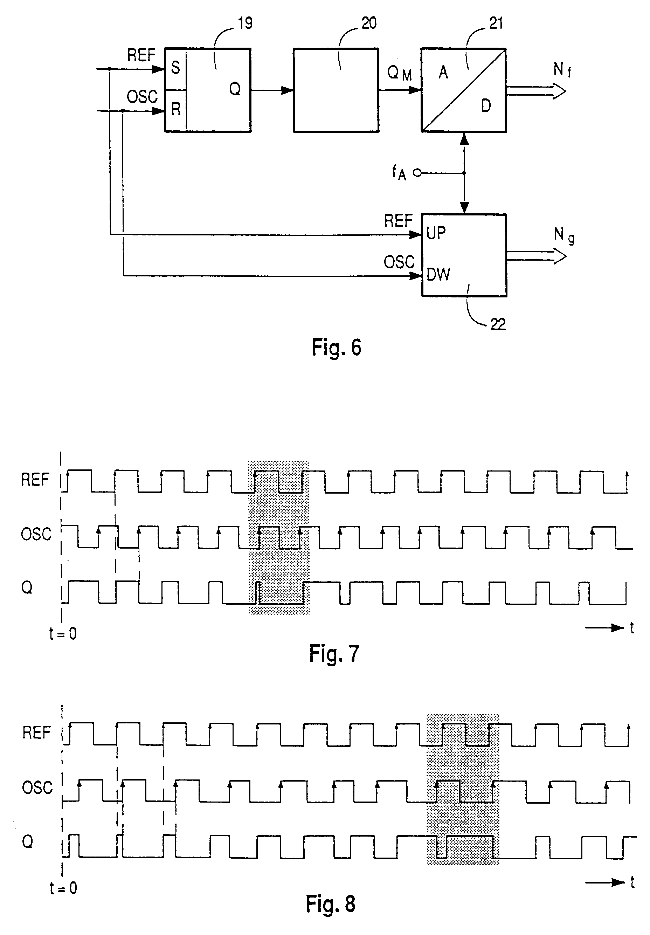

In Fig. 6 ist ein Phasendetektor dargestellt, der neben dem in allen Ausführungsbeispielen gleichen ersten Schaltungszweig eine erste Ausführungsform des zweiten Schaltungszweiges enthält. Am Eingang des ersten Schaltungszweiges des Phasendetektors ist ein flankengetriggertes Flipflop 19 angeordnet, auf dessen zwei Eingänge das Referenz- und Oszillatorsignal gegeben werden. Das Flipflop 19 wird bei einer positiven Flanke des Referenzsignals gesetzt und bei einer positiven Flanke des Oszillatorsignals rückgesetzt. Die Phasendifferenz von Referenz- und Oszillatorsignal wird in ein pulsbreitenmoduliertes impulsförmiges Signal Q umgesetzt. Das Tastverhältnis des impulsförmigen Signales Q beschreibt die Phasendifferenz im Bereich zwischen 0 und 2π. Eine Phasendifferenz von 0 entspricht einem Tastverhältnis von 0 und eine Phasendifferenz von 2π entspricht einem Tastverhältnis von 1. Phasendifferenzen, die größer als 2π oder kleiner als 0 sind, werden in den Bereich zwischen 0 und 2π transformiert, was einer Addition oder Subtraktion von ganzzahligen Vielfachen von 2π entspricht. Das Signal Q wird einem Tiefpaß 20 zugeführt, der das pulsbreitenmodulierte Signal Q in ein amplitudenmoduliertes Signal QM umwandelt. Dieses Signal wird einem Analog-Digital-Umsetzer 21 zugeführt, der das Signal abtastet, eine Quantisierung und anschließend eine Codierung mit Nf Bits durchführt. Die Abtastfrequenz ist gleich fA.

Im zweiten Schaltungszweig des Phasendetektors ist ein Vorwärts-Rückwärts-Zähler 22 angeordnet. Ihm werden das Referenz-und das Oszillatorsignal zugeführt. Der Zählerstand wird um den Wert 1 erhöht, wenn eine positive Flanke des Referenzsignals am ersten Eingang des Zählers 22 anliegt. Der Zählerstand wird um den Wert 1 erniedrigt, wenn eine positive Flanke des Oszillatorsignals am zweiten Eingang des Zählers 22 anliegt. Der Zählerstand ist damit gleich der Differenz aus der Anzahl an positiven Flanken des Referenzsignals und der Anzahl an positiven Flanken des Oszillatorsignals. Der kleinere von zwei aufeinanderfolgenden Zählerständen wird mit Ng Bits codiert, so daß Änderungen des Ausgangswertes des Zählers 22 nur bei 2π-Bereichsüberschreitungen auftreten. Zu Beginn der Anlaufphase der Phasenregelschleife wird der Zählerstand auf den Wert 0 gesetzt. Der codierte Zählerstand des Zählers 22 wird ausgelesen, wobei der Zähler 22 mit der Frequenz fA getaktet ist. Zusammen mit den Ausgangsbits des Analog-Digital-Umsetzers 21 werden die Ausgangsbits des Zählers 22 dem digitalen Regler der Phasenregelschleife zugeführt.

In den Fig. 7 und 8 sind für zwei Beispielfälle die Zeitverläufe von Referenzsignal, Oszillatorsignal und dem Ausgangssignal des Flipflops 19 dargestellt. Willkürlich wurde ein Bezugszeitpunkt t = 0 festgelegt, bei dem der Zählerstand des Zählers 22 auf 0 steht. Im schraffierten Bereich von Fig. 7 unterschreitet die Phasendifferenz den Wert 0. Man erkennt, daß in diesem Bereich zwischen zwei positiven Flanken des Referenzsignales zwei positive Flanken des Oszillatorsignales liegen. Der Zählerstand wird um den Wert 1 erniedrigt, d.h. auf den Zählerstand -1 gesetzt. Im schraffierten Bereich von Fig. 8 überschreitet die Phasendifferenz den Wert 2π. In diesem Bereich liegt zwischen zwei positiven Flanken des Referenzsignales keine positive Flanke des Oszillatorsignales. Der Zählerstand wird von 0 auf 1 erhöht.

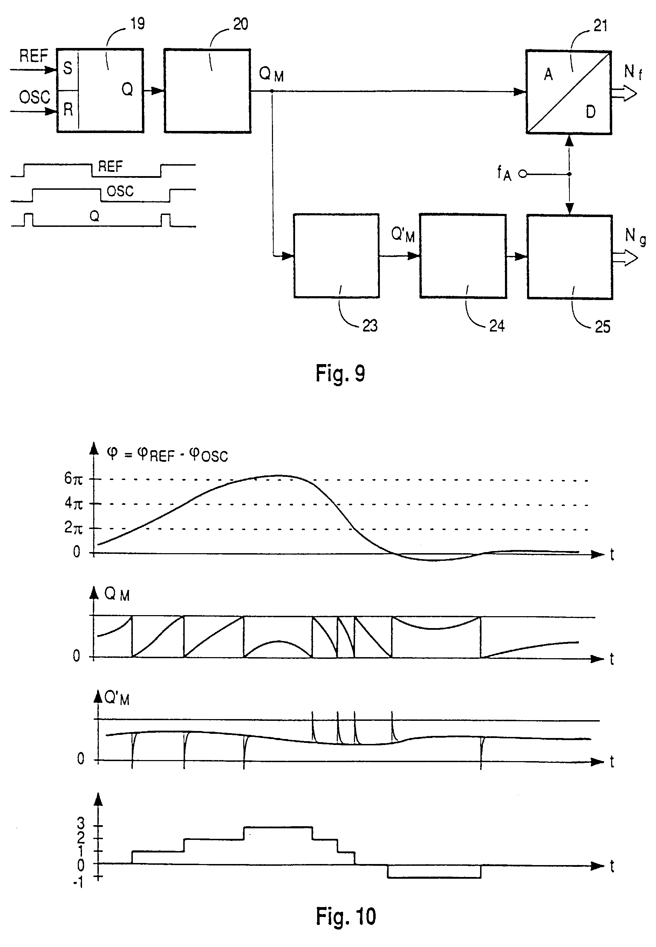

In Fig. 9 ist ein zweites Ausführungsbeispiel des Phasendetektors dargestellt. Der erste Schaltungszweig des Phasendetektors ist identisch mit dem in Fig. 6 dargestellten ersten Schaltungszweig. Die zweite Ausführungsform des zweiten Schaltungszweiges ist an den Ausgang des Tiefpasses 20 gekoppelt. Das Ausgangssignal QM des Tiefpasses 20 wird einem Hochpaß 23 zugeführt, der näherungsweise als Differentiator wirkt. Der Ausgang des Hochpasses ist mit einem Schwellwertentscheider gekoppelt, der das Überschreiten einer ersten Schwelle und das Unterschreiten einer zweiten Schwelle detektiert. Das Ausgangssignal des Schwellwertentscheiders 24 wird einem Vorwärts-Rückwärts-zähler 25 zugeführt. Dessen Zählerstand wird mit Ng Bits codiert.

Anhand von Fig. 10 wird die Funktionsweise des in Fig. 9 dargestellten zweiten Schaltungszweiges des Phasendetektors deutlich. Im ersten Diagramm von Fig. 10 ist ein beispielhafter Verlauf der Phasendifferenz von Referenz-und Oszillatorsignal angegeben. Das zweite Diagramm zeigt den dazugehörigen zeitlichen Verlauf des Ausgangssignals des Tiefpasses 20. Überschreitet bzw. unterschreitet die Phasendifferenz ganzzahlige Vielfache von 2π, so liegt an diesen Stellen eine steile abfallende oder ansteigende Flanke des Ausgangssignals des Tiefpasses 20 vor. Aus dem dritten Diagramm wird der Signalverlauf des Ausgangssignals des Hochpasses 23 ersichtlich, dessen Grenzfrequenz ungefähr um den Faktor 10 kleiner als die Grenzfrequenz des Tiefpasses 20 ist. Die Grenzfrequenz des Hochpasses ist allerdings um mehr als zwei Größenordnungen größer als die Grenzfrequenz der Grundwelle des Phasendifferenzsignals. Positive oder negative Flanken des Eingangssignales QM werden in positive oder negative Nadelimpulse umgesetzt. Die restlichen Signalanteile des Eingangssignales QM werden stark gedämpft. Im dritten Diagramm sind außerdem die positive und negative Schwelle des Schwellwertentscheiders 24 eingezeichnet. Nur die Nadelimpulse liegen außerhalb des Bereichs zwischen diesen beiden Schwellen. Beim Unterschreiten der unteren Schwelle des Schwellwertentscheiders 24 gibt dieser einen ersten Zählimpuls an den Vorwärts-Rückwärts-Zähler 25, so daß dessen Zählerstand um 1 erhöht wird. Beim Überschreiten der oberen Schwelle des Schwellwertentscheiders 24 wird analog der Zählerstand um 1 erniedrigt. Der zeitliche Verlauf des Zählerstandes im vorliegenden Beispiel wird aus dem vierten Diagramm von Fig. 10 deutlich. Der Zählerstand wird wiederum mit der Abtastfrequenz fA abgetastet und mit Ng höherwertigen Bits codiert.

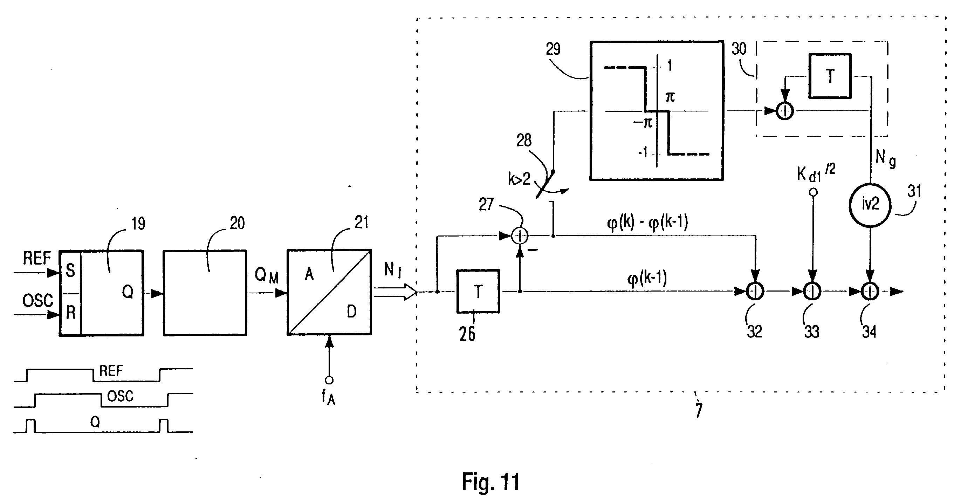

In Fig. 11 ist eine dritte Ausführungsform des zweiten Schaltungszweiges 7 des Phasendetektors 1 dargestellt. Der Eingang des zweiten Schaltungszweiges 7 ist mit dem Ausgang des ersten Schaltungszweiges gekoppelt. Der zweite Schaltungszweig 7 ist im Digitalteil der Phasenregelschleife realisiert.

Am Eingang des zweiten Schaltungszweiges ist ein Verzögerungsglied 26 angeordnet. Ein Subtrahierer 27 ist mit dem Eingang des zweiten Schaltungszweiges und dem Ausgang des Verzögerungsgliedes 26 verbunden und bildet die Differenz zweier aufeinanderfolgender Abtastwerte der Phasendifferenz. Über einen Schalter 28, der ab dem dritten Abtastwert der Phasendifferenz geschlossen ist, ist der Ausgang des Subtrahierers 27 mit dem Eingang eines Schwellwertentscheiders 29 gekoppelt. Ist die Differenz zweier aufeinanderfolgender Abtastwerte der Phasendifferenz betragsmäßig kleiner als π, so liefert der Schwellwertentscheider 29 den Ausgangswert 0. Ist die Differenz größer oder gleich π bzw. kleiner oder gleich -π, so liefert der Schwellwertentscheider 29 den Ausgangswert -1 bzw. 1. Ist die Abtastfrequenz fA der Phasendifferenz genügend groß gewählt, wird jede steile Flanke des Ausgangssignals des Tiefpasses 20 und damit jede 2π-Bereichsüberschreitung der Phasendifferenz erkannt. In diesen Fällen liegt am Ausgang des Schwellwertentscheiders 29 der Wert -1 bzw. 1 an. Die Ausgangswerte des Schwellwertentscheiders 29 werden auf einen digitalen Akkumulator 30 gegeben. Dieser besitzt die Funktion eines Vorwärts-Rückwärts-Zählers. Am Ausgang des Akkumulators 30 liegen Ng höherwertige Bits an. Diese werden mit Hilfe des Multplizierers 31 in die zugehörigen höherwertigen Lagen verschoben.

Ein erster Addierer 32 dient zur Addition der Ausgangswerte des Verzögerungsgliedes 26 und des Subtrahierers 27. Er rekonstruiert den vom ersten Schaltungszweig gelieferten aktuellen Abtastwert der Phasendifferenz. Mit Hilfe eines zweiten Addierers 33 wird auf diesen Zahlenwert der Wert Kd1/2 aufaddiert. Die Zahl Kd1/2 entspricht dem halben nutzbaren Bereich der Sägezahnkennlinie, d.h. der halben Breite eines Sägezahns. Diese Addition bewirkt eine Zentrierung des Arbeitspunktes. Ein dritter Addierer 34 addiert die Ausgangswerte des zweiten Addierers 33 und des Multiplizierers 31. Er faßt die Nf niederwertigen Bits des ersten Schaltungszweiges und die Ng höherwertigen Bits des zweiten Schaltungszweiges zusammen. Der Ausgangswert stellt die Phasendifferenz von Referenz- und Oszillatorsignal dar. Diese Zahlenwerte werden auf den digitalen Regler der Phasenregelschleife gegeben.

## Patentansprüche

1. Digitale Phasenregelschleife mit einem Regler (2), dessen Ausgang mit einem steuerbaren Oszillator (3) gekoppelt ist, und mit einem eine Zählvorrichtung (22,25,30) aufweisenden Phasendetektor (1), dessen zwei Eingänge zum Empfang eines Referenzsignals (REF) und eines vom Oszillator (3) zu erzeugenden Oszillatorsignals (OSC) vorgesehen sind,
dadurch gekennzeichnet,
- daß der Phasendetektor (1) einen zum Empfangen des impulsförmigen Referenzsignals (REF) und des impulsförmigen Oszillatorsignals (OSC) vorgesehenen ersten Schaltungszweig (36) zur Bildung eines impulsförmigen Signals (Q) und zur Tiefpaßfilterung des impulsförmigen Signals (Q) sowie zur Codierung eines abgetasteten ersten Wertes (Nf) des tiefpaßgefilterten Signals (QM) mit einer Anzahl an niederwertigen Bits aufweist, wobei der erste Wert (Nf) aus der Zeitdifferenz zwischen Referenzpunkten der beiden Eingangssignale (REF,OSC) des Phasendetektors (1) gebildet wird, und
- daß der Phasendetektor (1) einen an den ersten Schaltungskreis (36) gekoppelten zweiten Schaltungszweig (7) zur Codierung eines mittels der Zählvorrichtung (22,25,30) zur Bildung einer ab einem Bezugszeitpunkt detektierten Differenz aus einer Anzahl von Referenzpunkten des Referenzsignals (REF) und einer Anzahl von Referenzpunkten des Oszillatorsignals (OSC) gebildeten zweiten Wertes (Ng) mit einer Anzahl an höherwertigen Bits aufweist,
- wobei die Werte (Nf,Ng) der beiden Schaltungskreise (36,7) zur Bildung eines die Phasendifferenz zwischen dem Referenzsignal (REF) und dem Oszillatorsignal (OSC) beschreibenden Wertes zusammengefaßt werden.

2. Digitale Phasenregelschleife nach Anspruch 1,
dadurch gekennzeichnet,
daß die Impulsbreiten des impulsförmigen Signals (Q) jeweils aus dem zeitlichen Abstand zweier bestimmter aufeinanderfolgender Impulsflanken von Referenz- und Oszillatorsignal (REF bzw. OSC) abgeleitet sind, die als ab einem Bezugszeitpunkt t = 0 detektierte Referenzpunkte dienen.

3. Digitale Phasenregelschleife nach Anspruch 1 oder 2,
dadurch gekennzeichnet,
daß im ersten Schaltungszweig (36) zur Bildung des impulsförmigen Signals ein Kippglied (19) vorgesehen ist.

4. Digitale Phasenregelschleife nach einem der Ansprüche 1 bis 3,
dadurch gekennzeichnet,
daß im zweiten Schaltungszweig (7) die Zählvorrichtung als Vorwärts-Rückwärtszähler (22), an dessen Eingängen das Referenz- und das Oszillatorsignal (REF, OSC) anliegen, ausgebildet ist.

5. Digitale Phasenregelschleife nach einem der Ansprüche 1 bis 3,
dadurch gekennzeichnet,
daß der Eingang des zweiten Schaltungszweiges (7) des Phasendetektors (1) zum Empfang des tiefpaßgefilterten impulsförmigen Signals des ersten Schaltungszweiges (36) vorgesehen ist,
daß am Eingang des zweiten Schaltungszweiges (7) ein Differentiator bzw. Hochpaß (23) angeordnet ist,
daß an den Ausgang des Differentiators bzw. Hochpasses (23) ein Schwellwertentscheider (24) gekoppelt ist und daß an den Ausgang des Schwellwertentscheiders (24) ein Vorwärts-Rückwärtszähler (25) gekoppelt ist.

6. Digitale Phasenregelschleife nach einem der Ansprüche 1 bis 3,
dadurch gekennzeichnet,
daß der zweite Schaltungszweig (7) des Phasendetektors (1) an den Ausgang des ersten Schaltungszweiges (36) gekoppelt ist,
daß der zweite Schaltungszweig (7) im Digitalteil der digitalen Phasenregelschleife angeordnet ist,
daß im zweiten Schaltungszweig (7) Mittel (26, 27) zur Bildung der Differenz zweier aufeinanderfolgender mit einer ersten Anzahl (Nf) an Bits codierter Abtastwerte der Phasendifferenz vorgesehen sind,
daß diese Differenz einem Schwellwertentscheider (29) zugeführt wird und
daß Mittel (30) zur Integration der Ausgangswerte des Schwellwertentscheiders (29) vorgesehen sind.

7. Digitale Phasenregelschleife nach einem der Ansprüche 1 bis 6,
dadurch gekennzeichnet,
daß im Digitalteil der Phasenregelschleife eine Verarbeitung der Phasendifferenz gemäß einer nichtlinearen Kennlinie (35) vorgesehen ist.

8. Digitale Phasenregelschleife nach einem der Ansprüche 1 bis 7,
dadurch gekennzeichnet,
daß die im zweiten Schaltungszweig (7) erzeugten höherwertigen Bits mit einem Gewichtsfaktor (31) multipliziert werden.

## Claims

1. Digital phase-locked loop with a controller (2), whose output is coupled to a controllable oscillator (3), and with a phase detector (1) which has a counting device (22, 25, 30) and whose two inputs are provided to receive a reference signal (REF) and an oscillator signal (OSC), which is to be produced by the oscillator (3), characterized
- in that the phase detector (1) has a first circuit path (36), which is provided to receive the pulsed reference signal (REF) and the pulsed oscillator signal (OSC), in order to form a pulsed signal (Q) and in order to subject the pulsed signal (Q) to low-pass filtering, and in order to code a sampled first value (Nf) of the low-pass-filtered signal (QM) with a number of less significant bits, the first value (Nf) being formed from the time difference between reference points in the two input signals (REF, OSC) of the phase detector (1), and
- in that the phase detector (1) has a second circuit path (7), coupled to the first circuit path (36), in order to code a second value (Ng) with a number of more significant bits, the said second value (Ng) being formed by means of the counting device (22, 25, 30) in order to form a difference, detected after a reference instant, from a number of reference points in the reference signal (REF) and a number of reference points in the oscillator signal (OSC),
- the values (Nf, Ng) from the two circuit paths (36, 7) being aggregated in order to form a value describing the phase difference between the reference signal (REF) and the oscillator signal (OSC).

2. Digital phase-locked loop according to Claim 1, characterized in that the pulse widths of the pulsed signal (Q) are derived in each case from the time interval between two specific successive pulse edges of the reference signal and the oscillator signal (REF and OSC) which serve as reference points detected after a reference instant t = 0.

3. Digital phase-locked loop according to Claim 1 or 2, characterized in that a multivibrator (19) is provided in the first circuit path (36) for forming the pulsed signal.

4. Digital phase-locked loop according to one of Claims 1 to 3, characterized in that in the second circuit path (7), the counting device is designed as an up/down counter (22) having the reference signal and the oscillator signal (REF, OSC) applied to its inputs.

5. Digital phase-locked loop according to one of Claims 1 to 3, characterized in that the input of the second circuit path (7) in the phase detector (1) is provided to receive the low-pass-filtered pulsed signal from the first circuit path (36), in that a differentiator or high-pass filter (23) is arranged at the input of the second circuit path (7), in that a threshold-value decision unit (24) is coupled to the output of the differentiator or high-pass filter (23), and in that an up/down counter (25) is coupled to the output of the threshold-value decision unit (24).

6. Digital phase-locked loop according to one of Claims 1 to 3, characterized in that the second circuit path (7) in the phase detector (1) is coupled to the output of the first circuit path (36), in that the second circuit path (7) is arranged in the digital part of the digital phase-locked loop, in that the second circuit path (7) is provided with means (26, 27) for forming the difference between two successive sample values of the phase difference which are coded with a first number (Nf) of bits, in that this difference is fed to a threshold-value decision unit (29), and in that means (30) are provided in order to integrate the output values from the threshold-value decision unit (29).

7. Digital phase-locked loop according to one of Claims 1 to 6, characterized in that the digital part of the phase-locked loop is provided with a means of processing the phase difference on the basis of a non-linear characteristic curve (35).

8. Digital phase-locked loop according to one of Claims 1 to 7, characterized in that the more significant bits produced in the second circuit path (7) are multiplied by a weighting factor (31).

## Revendications

1. Boucle à verrouillage de phase numérique avec un régulateur (2), dont la sortie est couplée à un oscillateur pilotable (3), et avec un détecteur de phase (1) qui présente un dispositif de comptage (22, 25, 30), dont les deux entrées sont prévues pour la réception d'un signal de référence (REF) et d'un signal d'oscillateur (OSC) généré par l'oscillateur (3),
caractérisé en ce que
le détecteur de phase (1) présente une première branche de circuit (36) prévue pour la réception du signal de référence (REF) en forme d'impulsions et du signal de l'oscillateur (OSC) en forme d'impulsions pour constituer un signal (Q) en forme d'impulsions et pour le filtrage passe-bas du signal (Q) en forme d'impulsions ainsi que pour le codage d'une première valeur (Nf) lue du signal (QM) filtré en passe-bas sur un certain nombre de bits de poids faible, la première valeur (Nf) étant formée par le délai entre des points de référence des deux signaux d'entrée (REF, OSC) du détecteur de phase (1) et en ce que
le détecteur de phase (1) présente une seconde branche de circuit (7) couplée à la première branche de circuit (36) pour le codage d'une seconde valeur (Ng) sur un certain nombre de bits de poids fort, formée au moyen du dispositif de comptage (22, 25, 30), pour constituer une différence, détectée à partir d'un instant de référence, entre un certain nombre de points de référence du signal de référence (REF) et un certain nombre de points de référence du signal de l'oscillateur (OSC),
les valeurs (Nf, Ng) des deux circuits (36, 7) étant regroupées pour constituer une valeur décrivant la différence de phase entre le signal de référence (REF) et le signal de l'oscillateur (OSC).

2. Boucle à verrouillage de phase numérique selon la revendication 1, caractérisée en ce que
les largeurs d'impulsions du signal (Q) en forme d'impulsions découlent à chaque fois du délai entre deux fronts successifs définis d'impulsions respectivement du signal de référence (REF) et du signal de l'oscillateur (OSC), qui servent de points de référence détectés à partir d'un instant de référence t = 0.

3. Boucle à verrouillage de phase numérique selon la revendication 1 ou 2, caractérisée en ce que
dans la première branche de circuit (36), une bascule (19) est prévue pour constituer le signal en forme d'impulsions.

4. Boucle à verrouillage de phase numérique selon l'une quelconque des revendications 1 à 3, caractérisée en ce que
dans la seconde branche de circuit (7), le dispositif de comptage est formé en tant que compteur - décompteur (22) aux entrées duquel les signaux de référence et de l'oscillateur (REF, OSC) sont appliqués.

5. Boucle à verrouillage de phase numérique selon l'une quelconque des revendications 1 à 3, caractérisée en ce que
l'entrée de la seconde branche de circuit (7) du détecteur de phase (1) est prévue pour recevoir le signal en forme d'impulsions filtré en passe-bas de la première branche de circuit (36), en ce
qu'un différentiateur, c'est-à-dire un passe-haut (23) est disposé à l'entrée de la seconde branche de circuit (7) et en ce
qu'un discriminateur à seuil (24) est couplé à la sortie du différentiateur, c'est-à-dire du passe-haut (23) et en ce
qu'un compteur - décompteur (25) est couplé à la sortie du discriminateur à seuil (24).

6. Boucle à verrouillage de phase numérique selon l'une quelconque des revendications 1 à 3, caractérisée en ce que
la seconde branche de circuit (7) du détecteur de phase (1) est couplée à la sortie de la première branche de circuit (36), en ce que
la seconde branche de circuit (7) est disposée dans la partie numérique de la boucle à verrouillage de phase numérique, en ce que
dans la seconde branche de circuit (7), des moyens (26, 27) sont prévus pour constituer la différence entre deux valeurs successives lues de la différence de phase, codées sur un premier nombre (Nf) de bits, en ce que
cette différence est acheminée vers un discriminateur à seuil (29) et en ce que
des moyens (30) sont prévus pour intégrer la valeur de sortie du discriminateur à seuil (29).

7. Boucle à verrouillage de phase numérique selon l'une quelconque des revendications 1 à 6, caractérisée en ce que
dans la partie numérique de la boucle à verrouillage de phase, un traitement de la différence de phase selon une caractéristique non linéaire (35) est prévu.

8. Boucle à verrouillage de phase numérique selon l'une quelconque des revendications 1 à 7, caractérisée en ce que
les bits de poids fort générés dans la seconde branche de circuit (7) sont multipliés par un facteur de pondération (31).
